# EUROPEAN PATENT SPECIFICATION

(11) **EP 4 597 136 B1**
(45) Date of publication and mention of the grant of the patent: **15.07.2026**
(21) Application number: 23872932.1
(22) Date of filing: 20.09.2023
(51) Int. Cl.: G01R 31/392, G01R 31/389, G01R 31/367, G01R 31/396, H01M 10/48, H01M 10/42, H01M 10/052

(54) **BATTERY CELL DIAGNOSIS DEVICE AND METHOD**
VORRICHTUNG UND VERFAHREN ZUR DIAGNOSE VON BATTERIEZELLEN
DISPOSITIF ET PROCÉDÉ DE DIAGNOSTIC DE CELLULE DE BATTERIE

(30) Priority: 30.09.2022 KR 20220125853
(43) Date of publication of application: 06.08.2025
(73) Proprietor: LG Energy Solution, Ltd., Seoul 07335 (KR)
(72) Inventor: SONG, Jae Hwan, Daejeon 34122 (KR)
(74) Representative: Plasseraud IP
(86) International application number: PCT/KR2023/014291
(87) International publication number: WO 2024/071814

(56) References cited:
- KR-A- 20140 130 232
- KR-A- 20160 108 963
- KR-A- 20180 016 493
- KR-A- 20180 016 493
- KR-A- 20180 045 374
- KR-A- 20220 068 806
- KR-A- 20220 068 806

## Description

### TECHNICAL FIELD

The present invention relates to a diagnosis apparatus and a diagnosis method of a battery cell, and more specifically, to an apparatus and a method for diagnosing a battery cell, which are capable of diagnosing the state of a battery cell.

### BACKGROUND ART

Recently, as the demand for portable electronic products such as laptops, video cameras, and portable phones has been rapidly increased and the development of electric vehicles, storage batteries for storing energy, robots, satellites, and the like has been in earnest, research on secondary batteries used as driving power is actively being conducted.

If at least one battery cell among a plurality of battery cells included in a battery pack experiences performance deterioration or failure, the overall performance of the battery pack may be degraded, so that the battery pack may not be stably operated.

Therefore, in recent years, there has been a demand for a method by which the performance of a battery cell is diagnosed to determine whether there is an abnormality in the battery cell. KR20220068806A relates to battery diagnosis technology capable of effectively diagnosing the state of a battery through an impedance measurement value.

### DISCLOSURE OF THE INVENTION

### TECHNICAL PROBLEM

An aspect of the present invention provides an apparatus according to claim 1 and a method for diagnosing a battery cell according to claim 15, which are capable of diagnosing the state of the battery cell.

Objects to be achieved by the present invention are not limited to the object mentioned above, and other objects not mentioned will be clearly understood by those skilled in the art from the following description.

### TECHNICAL SOLUTION

According to an embodiment, the reference cell module may include a housing having an inner space to accommodate the at least one reference cell, a protective cover for covering the inner space, and a first bus bar and a second bus bar spaced apart from each other with the protective cover interposed therebetween.

According to an embodiment, at least one of the first bus bar and the second bus bar may protrude further than the protective cover.

According to an embodiment, the reference cell may include a body accommodated in the inner space and storing charges, a first conductive terminal disposed on the body, and electrically connected to the first bus bar, and a second conductive terminal disposed on the body to be spaced apart from the first conductive terminal, and electrically connected to the second bus bar.

According to an embodiment, the reference cell module may further include a first conductive bar disposed on an inner side of the housing and bent from the first bus bar, and a second conductive bar disposed on the inner side of the housing to face the first conductive bar and bent from the second bus bar.

According to an embodiment, the first bus bar may be electrically connected to the first conductive terminal through the first conductive bar, and the second bus bar may be electrically connected to the second conductive terminal through the second conductive bar.

According to an embodiment, the battery cell diagnostic apparatus may further include a charger/discharger configured to charge and discharge the reference cell and being in electrical contact with the first bus bar and the second bus bar.

According to an embodiment, the charger/discharger may be seated on the protective cover.

According to an embodiment, the length of the charger/discharger may be the same as a separation distance between the first bus bar and the second bus bar.

According to an embodiment, the battery cell may include a lithium-ion battery cell configured to generate electricity by using an oxidation/reduction reaction.

According to an embodiment, the processor may determine that the battery cell is good, if the difference between the battery impedance and the reference impedance is within a threshold, and determine that the battery cell is defective, if the difference between the battery impedance and the reference impedance is greater than the threshold.

According to an embodiment, the impedance measuring device may re-measure the battery impedance of the battery cell determined to be defective, and the processor may determine that the battery cell is defective, if the difference between the re-measured battery impedance and the reference impedance is greater than a threshold, and determine that it is an abnormality in a measurement environment of the diagnosis apparatus, if the difference between the re-measured battery impedance and the reference impedance is within the threshold.

According to an embodiment, the impedance measuring device may re-measure the reference impedance, if it is determined to be the abnormality in the measurement environment, wherein the re-measured reference impedance may be updated in a memory.

According to an embodiment, the reference cell module may be provided in the form of a portable kit.

### ADVANTAGEOUS EFFECTS

According to an embodiment of the present invention, it is possible to determine an abnormality in a battery cell on the basis of a reference impedance measured by using a reference cell which has higher charge/discharge efficiency and a longer service life than a battery cell. The reference impedance of the reference cell may be maintained at a reliable level for a longer period of time than a battery impedance of the battery cell, so that reliability may be improved.

In addition, according to an embodiment of the present invention, it is possible to determine whether there is an abnormality in a measurement environment through the change in the impedance value of a battery cell.

In addition, a variety of effects that are directly or indirectly identified through the present document may be provided.

### BRIEF DESCRIPTION OF THE INVENTION

FIG. 1 is a block diagram showing a diagnostic apparatus of a battery cell according to the present invention.
FIG. 2 is a perspective view showing a reference cell module illustrated in FIG. 1.
FIG. 3 is an exploded perspective view showing a reference cell module illustrated in FIG. 2.
FIG. 4 is a flowchart showing a method for diagnosing a battery cell according to Example 1 of the present invention.
FIG. 5 is a graph showing a reference impedance and a battery impedance measured through an impedance measuring device according to Example 1 of the present invention.
FIG. 6 is a flowchart showing a method for diagnosing a battery cell according to Example 2 of the present invention.

### MODE FOR CARRYING OUT THE INVENTION

Hereinafter, preferred embodiments of the present invention will be described in detail with reference to the accompanying drawings so that those skilled in the art to which the present invention pertains may easily practice the embodiments. However, the present invention may be embodied in many different forms, and is not limited or restricted to the embodiments set forth herein.

In order to clearly explain the present invention, parts irrelevant to the description or detailed descriptions of related known technologies that may unnecessarily obscure the gist of the present invention have been omitted, and in the present specification, in adding reference numerals to elements of each drawing herein, the same or similar reference numerals shall be assigned to the same or similar elements throughout the specification.

In addition, it will be understood that words or terms used in the specification and claims of the present invention shall not be construed as being limited to having the meaning defined in commonly used dictionaries. It will be further understood that the words or terms should be interpreted as having meanings that are consistent with their meanings in the context and the technical idea of the invention, based on the principle that an inventor may properly define the meaning of the words or terms to best explain the invention.

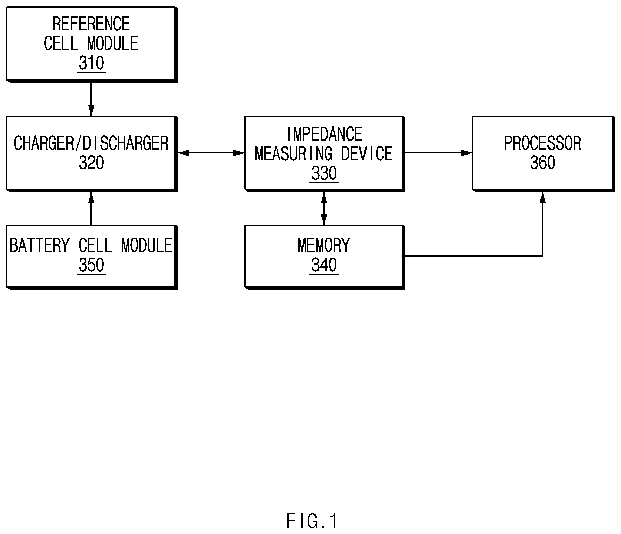

FIG. 1 is a block diagram showing a diagnostic apparatus of a battery cell according to the present invention.

Referring to FIG. 1, the diagnostic apparatus of a battery cell may include a charger/discharger 320, an impedance measuring device 330, a processor 360, and a memory 340.

When measuring a reference impedance of a reference cell module 310, the charger/discharger 320 may charge or discharge the reference cell module 310. One end of the charger/discharger 320 may be connected to a positive electrode terminal of the reference cell module 310, and the other end thereof may be connected to a negative electrode terminal of the reference cell module 310. The reference cell module 310 includes at least one reference cell. The reference cell may be an energy storage device which has higher charge/discharge efficiency and a longer service life than a battery cell. The reference cell is a super-capacitor.

When measuring a battery impedance of a battery cell module 350, the charger/discharger 320 may charge or discharge the battery cell module 350. One end of the charger/discharger 320 may be connected to a positive electrode terminal of the battery cell module 350, and the other end thereof may be connected to a negative electrode terminal of the battery cell module 350. The battery cell module 350 may include at least one battery cell. The battery cell may be a battery cell which generates electricity by using an oxidation/reduction reaction. For example, the battery cell may be a lithium-ion battery.

The charger/discharger 320 may be configured to apply an alternating current voltage to the reference cell module 310 in order to measure the reference impedance of the reference cell module 310. For example, the charger/discharger 320 may charge the reference cell module 310 by applying an alternating current voltage while changing a frequency. During the charging process, the impedance meter 330 may be configured to measure an internal impedance (or, reference impedance) of the reference cell module 310. As another example, the charger/discharger 320 may charge and discharge a reference cell module. During the charging/discharging process, the impedance measuring device 330 may be configured to measure the internal impedance of the reference cell module 310.

The impedance measuring device 330 may measure the reference impedance of the reference cell module 310 including a plurality of super-capacitors, as well as the battery impedance of the battery cell module 350. The impedance measuring device 330 may measure the reference impedance and the battery impedance by using, for example, electrochemical impedance spectroscopy (EIS).

The reference impedance and the battery impedance may be measured simultaneously or sequentially. In addition, the impedance measuring device 330 may be provided in plurality to respectively measure the reference impedance of the reference cell module 310 and the battery impedance of the battery cell module 350.

The memory 340 may store a reference impedance for each frequency. The memory 340 may be divided into a plurality of frequencies within a predetermined frequency range, and a reference impedance corresponding to each of the divided frequencies may be stored in a preset form. The reference impedance is a value which may be compared with the battery impedance of the battery cell module 350, and may be a value obtained in advance through at least one pre-measurement. In the memory 340, the reference impedance may be re-measured at regular intervals and updated periodically.

The processor 360 may determine whether there is an abnormality in the battery cell module 350 on the basis of a comparison result of the battery impedance and the reference impedance. If the difference between the battery impedance measured through the impedance measuring device 330 and the reference impedance stored in the memory 340 is within a preset threshold, the processor 360 may determine that the battery cell module 350 is good. If the difference between the battery impedance measured through the impedance measuring device 330 and the reference impedance stored in the memory 340 is greater than the preset threshold, the processor 360 may determine that the battery cell module 350 is defective.

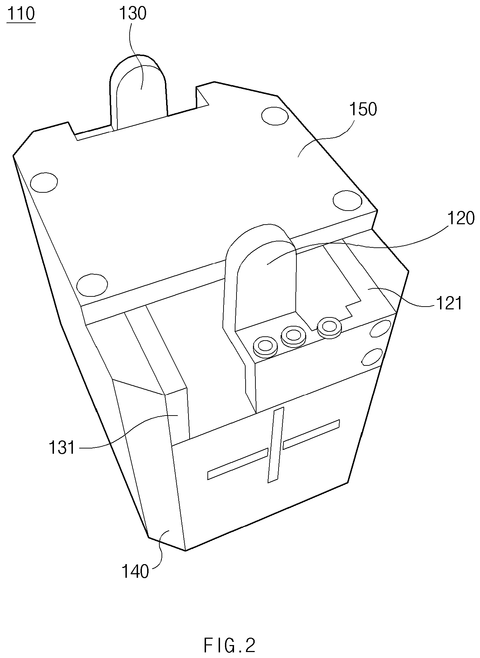

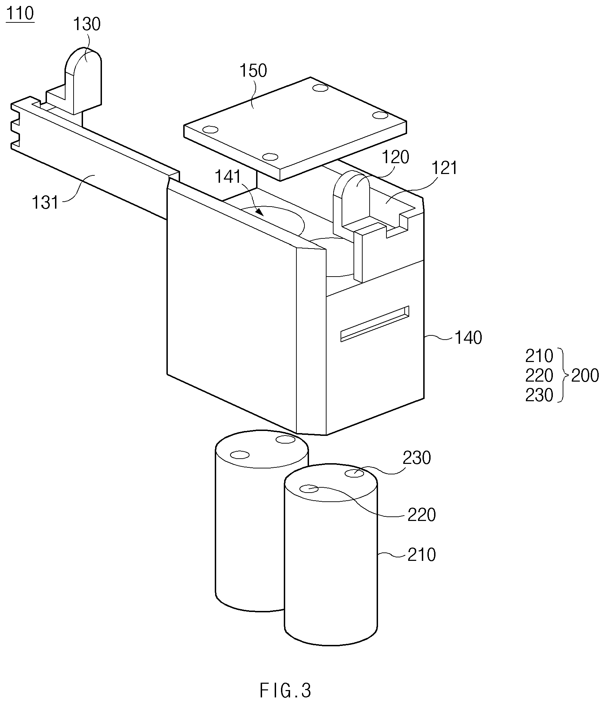

FIG. 2 is a perspective view showing a reference cell module illustrated in FIG. 1, and FIG. 3 is an exploded perspective view showing a reference cell module illustrated in FIG. 2.

Referring to FIG. 2 and FIG. 3, a reference cell module 110 (e.g., the reference cell module 310 of FIG. 1) according to an embodiment may be provided in the form of a portable kit. The reference cell module 110 may include a reference cell 200, a housing 140, first and second conductive bars 121 and 131, first and second bus bars 120 and 130, and a protective cover 150.

The housing 140 may include at least one inner space 141 in the form of a groove or hole. In the inner space 141 of the housing 140, at least one reference cell 200 may be accommodated. The housing 140 may be formed to surround a side surface or a lower surface of the reference cell 200, or may be formed to surround a side surface of the reference cell 200. If a plurality of reference cells 200 are accommodated in the housing 140, the plurality of reference cells 200 may be connected in series, parallel, or series-parallel.

The first and second bus bars 120 and 130 may be electrically connected to a charger/discharger (e.g., the charger/discharger 320 of FIG. 1). The first bus bar 120 may be electrically connected to a positive terminal of the charger/discharger, and the second bus bar 130 may be electrically connected to a negative terminal of the charge/discharger.

The first bus bar 120 and the second bus bar 130 may be configured to protrude further than the protective cover 150. The first bus bar 120 may protrude from the first conductive bar 121. The second bus bar 130 may protrude from the second conductive bar 131. The first bus bar 120 and the second bus bar 130 may be spaced apart from each other with the protective cover 150 interposed therebetween. A separation distance between the first bus bar 120 and the second bus bar 130 may correspond (e.g., the same) to the length of the charger/discharger to be seated on the protective cover 150.

The first conductive bar 121 and the second conductive bar 131 may be disposed on an inner side of the housing 140 formed of an insulation material. The first conductive bar 121 and the second conductive bar 131 may be disposed to face each other. The first conductive bar 121 may be bent from the first bus bar 120. The second conductive bar 131 may be bent from the second bus bar 130. For example, the first conductive bar 121 may be formed of the same conductive material as the conductive material of the first bus bar 120 and be integrated with the first bus bar 120. The second conductive bar 131 may be formed of the same conductive material as the conductive material of the second bus bar 130 and be integrated with the second bus bar 130. As another example, the first conductive bar 121 may be formed of a conductive material which is the same as or different from the conductive material of the first bus bar 120, and be electrically connected to the first bus bar 120 through a fastening member (e.g., a bolt and/or a nut). The second conductive bar 131 may be formed of a conductive material which is the same as or different from the conductive material of the second bus bar 130, and be electrically connected to the second bus bar 130 through a fastening member (e.g., a bolt and/or a nut).

The protective cover 150 may be coupled to the housing 140 and be formed in a single plate-shaped structure which covers the inner space 141 in which the reference cell 200 is accommodated. The protective cover 150 and the housing 140 may be coupled by welding or the like or fastened through a fastening member (e.g., a bolt and/or a nut) in a state in which corner portions thereof corresponding to each other are in contact with each other. The protective cover 150 and housing 140 may cover the reference cell 200 up, down, left and right. The reference cell 200 may be physically protected by means of the protective cover 150 and the housing 140. The protective cover 150 and the housing 140 may be formed of an insulation material having a predetermined strength.

The reference cell 200 may include a body 210, a first conductive terminal 220, and a second conductive terminal 230. For example, the first conductive terminal 220 may be a positive terminal, and the second conductive terminal 230 may be a negative terminal.

The body 210 may store charges. The body 210 may be formed in a shape corresponding to the inner space 141 of the housing 140 and be accommodated in the inner space 141 of the housing 140.

The first conductive terminal 220 is disposed on the body 210 and be extended unidirectionally from one side of the body 210. The first conductive terminal 220 may be electrically connected to the first bus bar 120 through the first conductive bar 121. The second conductive terminal 230 is disposed on the body 210 to be spaced apart from the first conductive terminal 220, and be extended unidirectionally from one side of the body 210. The second conductive terminal 230 may be electrically connected to the second bus bar 130 through the second conductive bar 131.

The reference cell 200 is a super-capacitor with the advantage of having better charge/discharge efficiency and a longer serve life than a battery cell (e.g., a lithium-ion battery cell). The super-capacitor may be rapidly charged/discharged and has high charge/discharge efficiency and semi-permanent cycle lifespan properties. The super-capacitor may store tens of times more energy per unit area than an ordinary capacitor. The super-capacitor is a capacitor having a large capacitance, and thus, is referred to as an ultra-capacitor or a super-capacitor. The super-capacitor may be composed of an electrode attached to a conductor and an electrolyte solution impregnated thereinto. An electrode with a pair of charge layers (electric double layer) having different signs generated on the interface may be used. Unlike a battery cell using a chemical reaction, the super-capacitor may be an energy storage device using simple ion movement to the interface between an electrode and an electrolyte or using charging phenomenon by a surface chemical reaction. The super-capacitor has an impedance that does not change even after repeated charge/discharge and that does not change even with deterioration over time, and thus, may be more reliable than a lithium-ion battery cell.

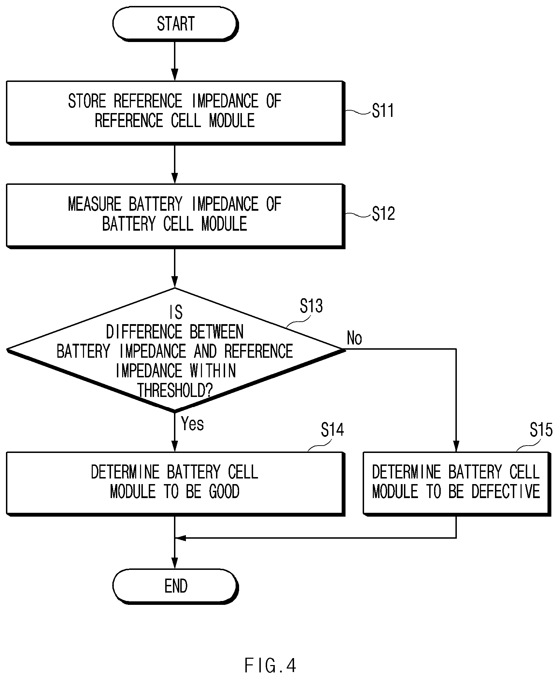

FIG. 4 is a flowchart showing a method for diagnosing a battery cell according to Example 1 of the present invention.

In Operation S11, an impedance measuring device (e.g., the impedance measuring device 330 of FIG. 1) may measure the impedance of a reference cell module (e.g., the reference cell module 310 of FIG. 1) including a super-capacitor. The measured impedance of the reference cell module may be stored as a reference impedance in a memory (e.g., the memory 340 of FIG. 1).

In Operation S12, the impedance measuring device may measure the battery impedance of a battery cell module (e.g., the battery cell module 350 of FIG. 1) including a lithium-ion battery cell.

In Operation S13, a processor (e.g., the processor 360 of FIG. 1) may compare the measured battery impedance with the reference impedance stored in the memory. The processor may determine whether the difference between the battery impedance and the reference impedance stored in the memory is within a threshold.

In Operation S14, as a result of the comparison, if the difference between the battery impedance and the reference impedance is within a preset threshold, the battery cell module may be determined to be good.

In Operation S15, as a result of the comparison, if the difference between the measured impedance and the reference impedance is out of (or exceeds) the threshold, the battery cell module may be determined to be defective.

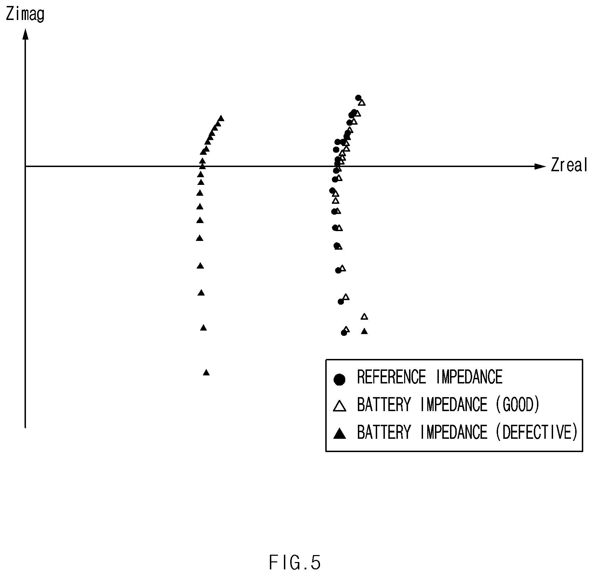

FIG. 5 is a drawing showing a reference impedance and a battery impedance measured through an impedance measuring device according to Example 1 of the present invention.

In FIG. 5, the horizontal axis may be referred to as a real-number component Zreal of an impedance, and the vertical axis may be referred to as an imaginary-number component Zimag of the impedance. The unit of the horizontal and vertical axes may be mΩ or Ω. In addition, each point may be referred to as an impedance point for each frequency. As the frequency changes, real-number and imaginary-number values of the impedance change, and an intersection point thereof may be represented as a point on coordinates, that is, an impedance point.

Referring to FIG. 5, the processor may receive and obtain, from an impedance measuring device (e.g., the impedance measuring device 330 of FIG. 1), a battery impedance for each frequency for a battery cell and a reference impedance for each frequency for a reference cell. The processor may compare a battery impedance point with a reference impedance point corresponding to a frequency which is the same as or similar to the frequency of the battery impedance point. If the battery impedance point is the same as the reference impedance point or is within a threshold (or, error range), the processor may determine that the battery cell is good. If the battery impedance point is out of a range within the threshold from the reference impedance point, the processor may determine that the battery cell is defective. As described above, the processor may diagnose the performance of the battery cell on the basis of an obtained impedance point for each frequency.

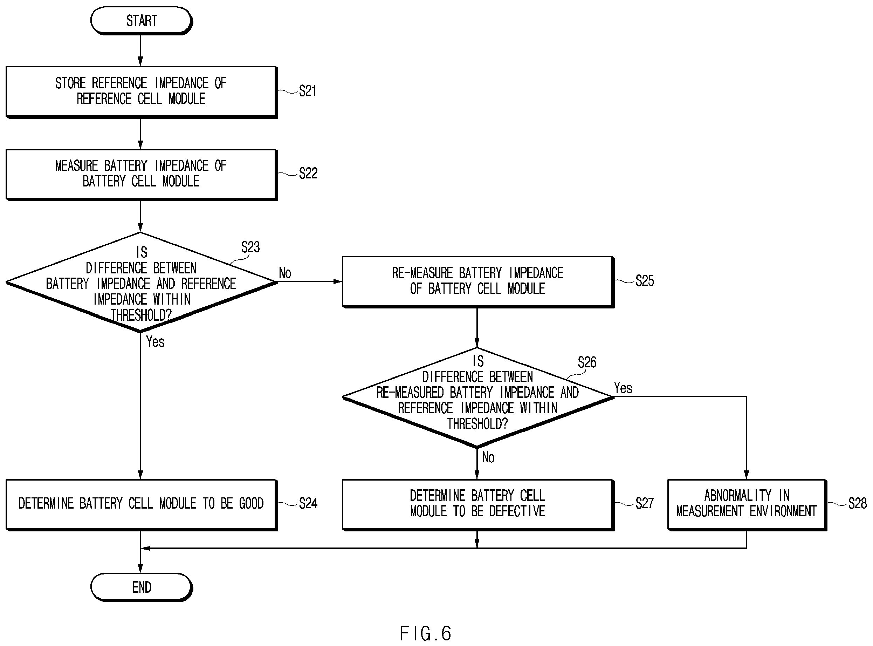

FIG. 6 is a flowchart showing a method for diagnosing a battery cell according to Example 2 of the present invention.

In Operation S21, an impedance measuring device (e.g., the impedance measuring device 330 of FIG. 1) may measure the impedance of a reference cell module (e.g., the reference cell module 310 of FIG. 1) including a super-capacitor. The measured impedance of the reference cell module may be stored as a reference impedance in a memory (e.g., the memory 340 of FIG. 1).

In Operation S22, the impedance measuring device may measure the battery impedance of a battery cell module (e.g., the battery cell module 350 of FIG. 1) including a lithium-ion battery cell.

In Operation S23, a processor (e.g., the processor 360 of FIG. 1) may compare the measured battery impedance with the reference impedance stored in the memory. The processor may determine whether the difference between the measured battery impedance and the reference impedance stored in the memory is within a threshold.

In Operation S24, as a result of the comparison, if the difference between the measured battery impedance and the reference impedance is within a preset threshold, the battery cell module may be determined to be good.

In Operation S25, as a result of the comparison, if the difference between the measured battery impedance and the reference impedance is out of the threshold, the impedance measuring device may re-measure at least one of the battery impedance of the battery cell module and the reference impedance of the reference cell module. For example, the impedance measuring device may re-measure the battery impedance of the battery cell module.

In Operation S26, the processor may compare the re-measured battery impedance with the reference impedance stored in the memory. The processor may re-determine whether the difference between the re-measured battery impedance and the reference impedance stored in the memory is within the threshold.

In Operation S27, if the difference between the re-measured battery impedance and the reference impedance is out of the threshold, the processor may determine that the battery cell module is defective.

In Operation S28, if the difference between the re-measured battery impedance and the reference impedance is within the threshold, the processor may determine that it is an abnormality in a measurement environment of the diagnosis apparatus. If it is determined that it is an abnormality in the measurement environment, an inspector may inspect whether it is an abnormality in the reference cell module, the battery cell module, or the diagnostic apparatus. If it is determined that it is an abnormality in the reference cell module, the reference cell module may be inspected. After the reference cell module is inspected, the impedance measuring device 330 re-measures the reference impedance, and the re-measured reference impedance may be updated in the memory.

The aforementioned battery cell module may be applied to a variety of devices. The aforementioned battery cell module may be applied to a transportation means such as an electric bicycle, an electric vehicle, and a hybrid, but is not limited thereto, and may be applied to various devices capable of using a battery cell module.

Although the present invention has been described with reference to the preferred embodiments and the drawings, it is to be understood that the invention is not limited thereto, and it is to be understood by those skilled in the art that various changes in form and details may be made therein without departing from the scope of the invention as defined by the following claims.

### [Description of the Reference Numerals or Symbols]

110, 310: Reference cell module
120, 130: Bus bar
140: Housing
150: Protective cover
200: Reference cell
320: Charger/discharger
330: Impedance measuring device
340: Memory
350: Battery cell module
360: Processor

## Claims

1. A diagnostic apparatus for inspecting the state of a battery cell, the apparatus comprising:
a reference cell module (110, 310) including at least one reference cell composed of a super-capacitor;
a measuring device (330) configured to measure a reference impedance of the reference cell and a battery impedance of the battery cell; and
a processor (360) configured to compare the battery impedance with the reference impedance to determine whether there is an abnormality in the battery cell.

2. The diagnostic apparatus of claim 1, wherein the reference cell module comprises:
a housing (140) having an inner space to accommodate the at least one reference cell;
a protective cover (150) for covering the inner space; and
a first bus bar (120) and a second bus bar (130) spaced apart from each other with the protective cover interposed therebetween.

3. The diagnostic apparatus of claim 2, wherein at least one of the first bus bar and the second bus bar protrudes further than the protective cover.

4. The diagnostic apparatus of claim 3, wherein the reference cell comprises:
a body accommodated in the inner space and storing charges;
a first conductive terminal disposed on the body, and electrically connected to the first bus bar; and
a second conductive terminal disposed on the body to be spaced apart from the first conductive terminal, and electrically connected to the second bus bar.

5. The diagnostic apparatus of claim 4, wherein the reference cell module further comprises:
a first conductive bar disposed on an inner side of the housing and bent from the first bus bar; and
a second conductive bar disposed on the inner side of the housing to face the first conductive bar and bent from the second bus bar.

6. The diagnostic apparatus of claim 5, wherein:
the first bus bar is electrically connected to the first conductive terminal through the first conductive bar; and
the second bus bar is electrically connected to the second conductive terminal through the second conductive bar.

7. The diagnostic apparatus of claim 2, further comprising a charger/discharger configured to charge and discharge the reference cell and being in electrical contact with the first bus bar and the second bus bar.

8. The diagnostic apparatus of claim 7, wherein the charger/discharger is seated on the protective cover.

9. The diagnostic apparatus of claim 7, wherein the length of the charger/discharger is the same as a separation distance between the first bus bar and the second bus bar.

10. The diagnostic apparatus of claim 1, wherein the battery cell comprises a lithium-ion battery cell configured to generate electricity by using an oxidation/reduction reaction.

11. The diagnostic apparatus of claim 1, wherein the processor is configured to:
determine that the battery cell is good, if the difference between the battery impedance and the reference impedance is within a threshold; and
determine that the battery cell is defective, if the difference between the battery impedance and the reference impedance is greater than the threshold.

12. The diagnostic apparatus of claim 11, wherein:
the impedance measuring device is configured to
re-measure the battery impedance of the battery cell determined to be defective; and
the processor is configured to:
determine that the battery cell is defective, if the difference between the re-measured battery impedance and the reference impedance is greater than a threshold; and
determine that it is an abnormality in a measurement environment of the diagnosis apparatus, if the difference between the re-measured battery impedance and the reference impedance is within the threshold.

13. The diagnostic apparatus of claim 12, wherein the impedance measuring device is configured to re-measure the reference impedance, if it is determined to be the abnormality in the measurement environment, wherein the re-measured reference impedance is updated in a memory.

14. The diagnostic apparatus of claim 1, wherein the reference cell module is provided in the form of a portable kit.

15. A diagnostic method for diagnosing the state of a battery cell, the method comprising:
measuring a reference impedance for at least one reference cell including a super-capacitor;
measuring a battery impedance for a battery cell including at least one battery cell; and
comparing the battery impedance with the reference impedance to determine whether there is an abnormality in the battery cell.

## Patentansprüche

1. Diagnoseeinrichtung zur Überprüfung des Zustands einer Batteriezelle, wobei die Einrichtung umfasst: ein Referenzzellenmodul(110, 310), das mindestens eine Referenzzelle enthält, die aus einem Superkondensator besteht; eine Messvorrichtung (330), die konfiguriert ist, um eine Referenzimpedanz der Referenzzelle und eine Batterieimpedanz der Batteriezelle zu messen; und einen Prozessor (360), der konfiguriert ist, um die Batterieimpedanz mit der Referenzimpedanz zu vergleichen, um zu bestimmen, ob eine Anomalie in der Batteriezelle vorliegt.

2. Diagnoseeinrichtung nach Anspruch 1, wobei das Referenzzellenmodul umfasst: ein Gehäuse (140) mit einem Innenraum zur Aufnahme der mindestens einen Referenzzelle; eine Schutzabdeckung (150) zum Abdecken des Innenraums; und eine erste Sammelschiene (120) und eine zweite Sammelschiene (130), die voneinander beabstandet sind, wobei die Schutzabdeckung dazwischen angeordnet ist.

3. Diagnoseeinrichtung nach Anspruch 2, wobei mindestens eine von der ersten Sammelschiene und der zweiten Sammelschiene weiter als die Schutzabdeckung vorsteht.

4. Diagnoseeinrichtung nach Anspruch 3, wobei die Referenzzelle umfasst: einen Körper, der in dem Innenraum untergebracht ist und Ladungen speichert; einen ersten leitenden Anschluss, der auf dem Körper angeordnet und elektrisch mit der ersten Sammelschiene verbunden ist; und einen zweiten leitenden Anschluss, der auf dem Körper so angeordnet ist, dass er von dem ersten leitenden Anschluss beabstandet ist, und elektrisch mit der zweiten Sammelschiene verbunden ist.

5. Diagnoseeinrichtung nach Anspruch 4, wobei das Referenzzellenmodul ferner umfasst: einen ersten leitenden Stab, der auf einer Innenseite des Gehäuses angeordnet und von der ersten Sammelschiene gebogen ist; und einen zweiten leitenden Stab, der auf der Innenseite des Gehäuses angeordnet ist, um dem ersten leitenden Stab gegenüberzuliegen, und von der zweiten Sammelschiene gebogen ist.

6. Diagnoseeinrichtung nach Anspruch 5, wobei: die erste Sammelschiene über den ersten leitenden Stab elektrisch mit dem ersten leitenden Anschluss verbunden ist; und die zweite Sammelschiene über den zweiten leitenden Stab elektrisch mit dem zweiten leitenden Anschluss verbunden ist.

7. Diagnoseeinrichtung nach Anspruch 2, ferner umfassend eine Lade-/Entladevorrichtung, die konfiguriert ist, um die Referenzzelle zu laden und zu entladen und in elektrischem Kontakt mit der ersten Sammelschiene und der zweiten Sammelschiene steht.

8. Diagnoseeinrichtung nach Anspruch 7, wobei die Lade-/Entladevorrichtung auf der Schutzabdeckung sitzt.

9. Diagnoseeinrichtung nach Anspruch 7, wobei die Länge der Lade-/Entladevorrichtung dieselbe ist wie ein Trennungsabstand zwischen der ersten Sammelschiene und der zweiten Sammelschiene.

10. Diagnoseeinrichtung nach Anspruch 1, wobei die Batteriezelle eine Lithium-Ionen-Batteriezelle umfasst, die konfiguriert ist, um durch Verwendung einer Oxidations-/Reduktionsreaktion Elektrizität zu erzeugen.

11. Diagnoseeinrichtung nach Anspruch 1, wobei der Prozessor konfiguriert ist zum: Bestimmen, dass die Batteriezelle gut ist, wenn die Differenz zwischen der Batterieimpedanz und der Referenzimpedanz innerhalb eines Schwellenwerts liegt; und Bestimmen, dass die Batteriezelle defekt ist, wenn die Differenz zwischen der Batterieimpedanz und der Referenzimpedanz größer ist als der Schwellenwert.

12. Diagnoseeinrichtung nach Anspruch 11, wobei: die Impedanzmessvorrichtung konfiguriert ist, um die Batterieimpedanz der als defekt bestimmten Batteriezelle neu zu messen; und der Prozessor konfiguriert ist, um: zu bestimmen, dass die Batteriezelle defekt ist, wenn die Differenz zwischen der neu gemessenen Batterieimpedanz und der Referenzimpedanz größer als ein Schwellenwert ist; und zu bestimmen, dass es sich um eine Anomalie in einer Messumgebung der Diagnosevorrichtung handelt, wenn die Differenz zwischen der neu gemessenen Batterieimpedanz und der Referenzimpedanz innerhalb des Schwellenwerts liegt.

13. Diagnosevorrichtung nach Anspruch 12, wobei die Impedanzmessvorrichtung konfiguriert ist, um die Referenzimpedanz neu zu messen, wenn bestimmt wird, dass es sich um die Anomalie in der Messumgebung handelt, wobei die neu gemessene Referenzimpedanz in einem Speicher aktualisiert wird.

14. Diagnoseeinrichtung nach Anspruch 1, wobei das Referenzzellenmodul in Form eines tragbaren Bausatzes bereitgestellt wird.

15. Diagnoseverfahren zur Diagnose des Zustands einer Batteriezelle, wobei das Verfahren umfasst: Messen einer Referenzimpedanz für mindestens eine Referenzzelle, die einen Superkondensator enthält; Messen einer Batterieimpedanz für eine Batteriezelle, die mindestens eine Batteriezelle enthält; und Vergleichen der Batterieimpedanz mit der Referenzimpedanz, um zu bestimmen, ob eine Anomalie in der Batteriezelle vorliegt.

## Revendications

1. Appareil de diagnostic pour inspecter l'état d'une cellule de batterie, l'appareil comprenant :
un module de cellule de référence (110, 310) incluant au moins une cellule de référence composée d'un supercondensateur ;
un dispositif de mesure (330) configuré pour mesurer une impédance de référence de la cellule de référence et une impédance de batterie de la cellule de batterie ; et
un processeur (360) configuré pour comparer l'impédance de batterie avec l'impédance de référence pour déterminer s'il existe une anomalie dans la cellule de batterie.

2. Appareil de diagnostic selon la revendication 1, dans lequel le module de cellule de référence comprend :
un boîtier (140) ayant un espace intérieur pour loger l'au moins une cellule de référence ;
un couvercle de protection (150) pour couvrir l'espace intérieur ; et
une première barre de bus (120) et une seconde barre de bus (130) espacées l'une de l'autre avec le couvercle de protection interposé entre elles.

3. Appareil de diagnostic selon la revendication 2, dans lequel au moins l'une de la première barre de bus et de la seconde barre de bus fait saillie plus loin que le couvercle de protection.

4. Appareil de diagnostic selon la revendication 3, dans lequel la cellule de référence comprend :
un corps logé dans l'espace intérieur et stockant des charges ;
une première borne conductrice disposée sur le corps, et connectée électriquement à la première barre de bus ; et
une seconde borne conductrice disposée sur le corps pour être espacée de la première borne conductrice, et connectée électriquement à la seconde barre de bus.

5. Appareil de diagnostic selon la revendication 4, dans lequel le module de cellule de référence comprend en outre :
une première barre conductrice disposée sur un côté intérieur du boîtier et pliée à partir de la première barre de bus ; et
une seconde barre conductrice disposée sur le côté intérieur du boîtier pour faire face à la première barre conductrice et pliée à partir de la seconde barre de bus.

6. Appareil de diagnostic selon la revendication 5, dans lequel:
la première barre de bus est connectée électriquement à la première borne conductrice par l'intermédiaire de la première barre conductrice ; et
la seconde barre de bus est connectée électriquement à la seconde borne conductrice par l'intermédiaire de la seconde barre conductrice.

7. Appareil de diagnostic selon la revendication 2, comprenant en outre un chargeur/déchargeur configuré pour charger et décharger la cellule de référence et étant en contact électrique avec la première barre de bus et la seconde barre de bus.

8. Appareil de diagnostic selon la revendication 7, dans lequel le chargeur/déchargeur est placé sur le couvercle de protection.

9. Appareil de diagnostic selon la revendication 7, dans lequel la longueur du chargeur/déchargeur est la même qu'une distance de séparation entre la première barre de bus et la seconde barre de bus.

10. Appareil de diagnostic selon la revendication 1, dans lequel la cellule de batterie comprend une cellule de batterie au lithium-ion configurée pour générer de l'électricité en utilisant une réaction d'oxydoréduction.

11. Appareil de diagnostic selon la revendication 1, dans lequel le processeur est configuré pour :
déterminer que la cellule de batterie est bonne, si la différence entre l'impédance de batterie et l'impédance de référence est sous un seuil ; et
déterminer que la cellule de batterie est défectueuse, si la différence entre l'impédance de batterie et l'impédance de référence est supérieure au seuil.

12. Appareil de diagnostic selon la revendication 11, dans lequel:
le dispositif de mesure d'impédance est configuré pour
remesurer l'impédance de batterie de la cellule de batterie déterminée comme étant défectueuse ; et
le processeur est configuré pour :
déterminer que la cellule de batterie est défectueuse, si la différence entre l'impédance de batterie remesurée et l'impédance de référence est supérieure à un seuil ; et
déterminer qu'il s'agit d'une anomalie dans un environnement de mesure de l'appareil de diagnostic, si la différence entre l'impédance de batterie remesurée et l'impédance de référence est à l'intérieur du seuil.

13. Appareil de diagnostic selon la revendication 12, dans lequel le dispositif de mesure d'impédance est configuré pour remesurer l'impédance de référence, s'il est déterminé qu'il s'agit de l'anomalie dans l'environnement de mesure, dans lequel l'impédance de référence remesurée est mise à jour dans une mémoire.

14. Appareil de diagnostic selon la revendication 1, dans lequel le module de cellule de référence est fourni sous la forme d'un kit portable.

15. Procédé de diagnostic pour diagnostiquer l'état d'une cellule de batterie, le procédé comprenant :
la mesure d'une impédance de référence pour au moins une cellule de référence incluant un supercondensateur ;
la mesure d'une impédance de batterie pour une cellule de batterie incluant au moins une cellule de batterie ; et
la comparaison de l'impédance de batterie avec l'impédance de référence pour déterminer s'il existe une anomalie dans la cellule de batterie.
